# EUROPEAN PATENT SPECIFICATION

(11) **EP 2 447 990 B1**
(45) Date of publication and mention of the grant of the patent: **23.12.2020**
(21) Application number: 11184967.5
(22) Date of filing: 13.10.2011
(51) Int. Cl.: H01L 23/13, H01L 23/538, H01L 25/07, H05K 1/02, H01L 23/00

(54) **Base plate**
Grundplatte
Plaque de base

(30) Priority: 02.11.2010 EP 10189684
(43) Date of publication of application: 02.05.2012
(73) Proprietor: ABB Power Grids Switzerland AG, 5400 Baden (CH)
(72) Inventor: Feller, Lydia, 8004 Zürich (CH); Hartmann, Samuel, 5603 Staufen (CH)
(74) Representative: Michalski Hüttermann & Partner Patentanwälte mbB

(56) References cited:
- EP-A1- 1 820 870
- EP-A1- 1 956 110
- EP-A1- 1 973 157
- EP-A1- 2 012 354
- WO-A1-01/08219
- WO-A1-2008/123172
- DE-A1- 19 707 514
- JP-A- 2003 204 022
- US-A1- 2006 035 069

## Description

### Technical Field

The Invention relates to a base plate, in particular for a power module.

### Background Art

Thermal management is one of the key issues for the package of power modules, or high power semiconductors, respectively, since the use of power semiconductors lead to losses which generates heat. The heat generated at the dies has to be extracted to the environment through a heat sink. The modules are mounted on the heat sink and the heat is flowing through the internal structure of the module through the base plate to the heat sink where the base plate is one of the main contributions to the thermal resistance. Therefore, the optimization and the reduction of the heat resistance of the base plate have a major impact on the thermal management and the reliability and lifetime of a high power semiconductor module.

Known from EP 2 012 354 A1 is a base plate for a power module comprising an aluminium silicon carbide composite and aluminium layers made of a metal containing aluminium as the main component formed on respective principal planes of the aluminium silicon carbide composite. In order to reduce a gap between the base plate and a heat-dissipation fin, or heat sink, respectively, the base plate is formed to have a convex bow.

Known from EP 1 973 157 A1 is a base plate for a power module comprising an aluminium silicon carbide composite that is a flat plate-shaped silicon carbide porous body impregnated with a metal containing aluminium as the main component, and an aluminium layer made of a metal containing aluminium as the main component formed only on one of the principal planes of the aluminium silicon carbide composite. Again, the base plate is formed to have a convex bow in order to reduce a gap between the base plate and a heat-dissipation fin, or heat sink, respectively.

These base plates have limited ability to be adapted to the topography, or roughness, respectively, of the surface of the heat sink. This may lead to the formation of voluminous cavities between the base plate and the surface of the heat sink, thereby reducing the heat-dissipation properties. Furthermore, these base plates often are secured to the internal structure of the power module as well as to the heat sink with internal tension in order to get sufficient heat-dissipation properties. Consequently, there may be a risk of the base plate to crack.

Known from Proceedings PCIM Europe 2009 Conference, Ayumi Maruta, Mitsuharu Tabata, 2500A/1200V Dual IGBT Module, is a layout of a power module which comprises a cooling fin on which a plurality of separated base plates, or base plate sections, respectively, are arranged.

WO 2008/123172 A1 relates to a heat spreader module, a heat sink, and methods of manufacturing them. The heat spreader module is disposed be-tween a semiconductor device and an aluminum cooling fin. The heat spreader module includes: an insulating substrate made of ceramic; and a semiconductor device; a substrate upper circuit provided on a surface facing the cooling fin; and a heat conductive substrate disposed on a surface of the insulating substrate facing the cooling fin.

In case a base plate is joined with a heat sink, usually a heat dissipation grease, gel, or mat, having high thermal conductivity is applied to the portions to be joined, and the base plate is fixed to the heat sink, or a heat-dissipation unit, respectively by screws through holes provided in the peripheral portion of the base plate. In the layout like described above, sometimes the formation of gaps between the respective base plates cannot completely be avoided. These gap-formations may thus lead to a leakage of the grease through the gaps or to the risk that materials such as low molecular weight molecules of the gel, other particles, or the like diffuse from the inside of the module to the outside. A loss of grease may lead to the disadvantage that the heat dissipation effect from the base plate to the heat sink may be reduced.

### Summary of invention

It is therefore an object of the invention to provide an improved base plate which shall obviate at least one of the disadvantages known in the art.

This object is achieved by a base plate according to claim 1. Preferred embodiments of the present invention are defined in the dependent claims.

The base plate according to the invention is in particular suitable for a power module. It comprises a matrix formed of metal, in particular of aluminium, wherein at least two reinforcements are provided in said matrix next to each other, and wherein the reinforcements are spaced apart from each other and are plate-shaped.

Consequently, according to the invention, the base plate has at least two independent and separated reinforcements which may act as a heat spreader to extract the heat from the power module, or the internal structure of the latter, to the heat sink. The separated reinforcements are thereby arranged in the matrix and may thus form inserts which are preferably fully embedded in the matrix.

The reinforcements are thereby more stiff compared to the matrix, which in turn is more ductile compared to the reinforcements. The stability is thus mainly formed by the reinforcements, whereas the matrix as such is formed of a more flexible material. Preferably, the more ductile matrix material completely surrounds the stiff reinforcements and holds the reinforcements together.

Due to the discontinuous structure of the reinforcements having a large structural strength, the base plate as a whole is flexible within certain limits especially at the gaps between the reinforcements. This effect is especially distinct, if the matrix is formed of a ductile metal, such as aluminium. In this regard, according to the invention, a matrix formed of aluminium means that the matrix is formed of pure aluminium or of a metal having aluminium as a main constituent.

The base plate according to the invention may thus be very well adapted to the geometry and topography of the surface of the heat sink as the reinforcements as such may react independent to each other. This adaption leads to a very close contact between the surface of the heat sink and the base plate despite a potentially rough surface, or undesired unevenness, of the heat sink. This very close contact leads to a prevention of many voluminous thermally insulating cavities between the surface of the heat sink and the base plate and thus to an improved heat transfer between the latter. The heat dissipation properties of a power module comprising a base plate according to the invention are consequently improved.

Additionally, due to the provision of independent and separated reinforcements, the internal stress in the base plate is strongly reduced leading to a much lower risk of cracking and thus of destroying the base plate. The durability, or lifetime, respectively, of the base plate is thus improved. Next to that, the stress inside the power module is reduced. As an example, there is provided less substrate bending during mounting of the power module.

Furthermore, due to the fact that the discontinuous and separated reinforcements are arranged in the continuous and more ductile matrix material, the heat sink as a whole is covered by the base plate. Consequently, a leakage of heat dissipation grease, e.g. due to an elevated temperature, may be securely avoided. As such a leakage would lead to reduced heat-dissipation properties, the durability of the heat dissipation properties is improved. Therefore, the disadvantages of the provision of several base plates like known in the state of the art are obviated. Additionally, a contamination may securely be avoided.

The reinforcements as well as the surrounding material, i.e. the matrix, are preferably formed in a plate-shaped manner. According to the invention, the expression "plate-shaped" shall mean that the width and/or length are bigger with respect to the height. This enables the base plate to be well introduced and used in a power module, thereby enabling good heat dissipation properties.

A plurality of through holes for securing the base plate to a heat sink is provided in the matrix along the length as well as along the width of the base plate, wherein no reinforcement is provided between the through holes along the width of the base plate. In detail, along the length of the base plate, preferably more than two through holes are provided, whereas along the width two through holes may be sufficient. This enables an improved flexibility of the base plate and furthermore reduces the stress inside the latter. In the region of the matrix, the material is ductile, thus enabling a secure fixation of the base plate to the heat sink, for example.

Along the width, or along the length shall mean that the through holes are provided essentially in one line extending in the direction of the width, or the length, respectively. The width shall thereby mean the shorter side of the base plate, whereas the length shall mean the longer side of the latter.

In further a preferred embodiment of the present invention, the at least two reinforcements are formed from silicon carbide (SiC). This is a ceramic reinforcement which has a high mechanical strength leading to a good stability of the composites. Furthermore, silicon carbide ceramics do not change their shape, bulk, or properties during their lifetime. As aluminium, for example, as well has good stability properties with respect to durability and thermal stability, especially in combination with a matrix being formed of aluminium no plastic deformation and no internal cracking of the mounted base plate occurs.

Additionally, silicon carbide exhibits high thermal conductivity, which lies in the range of more than 180W/mK, in particular in the range of 180W/mK - 200W/mK. Therefore, this material and thus the base plate according to the invention have very good heat extraction properties. However, each material combination which is appropriate may be used.

According to a further embodiment of the present invention, the reinforcements are arranged with a distance from each other in the range of 1mm to 5mm, in particular of 3mm. This arrangement allows a good covering of the heat sink with the reinforcements thereby allowing the reinforcements acting independent from each other and the base plate to be flexible. This enables a very close contact of the base plate to the surface of the heat sink.

According to a still further embodiment of the present invention, the base plate is at least partly formed as a bow. This enables a gap, which is potentially present between the surface of the heat sink and the base plate, being reduced. Accordingly, in this embodiment, the contact of the base plate to the surface of the heat sink may still further be improved. Due to the provision of independent and separated reinforcements, the base plate according to the invention is thereby enabled to sustain bending stress.

With this regard, a preferred geometry of the bow may be defined by the maximum bow deflection height which preferably is 100µm ± 50µm. Such a bow has improved properties with respect to a contact between the heat sink and the base plate.

Due to the fact, that the reinforcements which are embedded in the matrix are separated from each other, a bow may be formed only over the width of the base plate. The formation of a bow over the full length of the base plate is not necessary; it may be reduced to only a half or a third of the base plate. In an alternative, a bow over the length of the base plate is completely avoided. This leads to the advantage that only one curvature has to be pressed, or formed, respectively. The base plate may thus be produced with a higher reproducibility and in a less complex manner.

According to yet another preferred embodiment of the present invention, all reinforcements together have dimensions of at least 70% with respect to the dimension of the base plate, in particular of at least 85% with respect to the dimension of the base plate. This leads to sufficiently high heat extraction properties which mainly are affected by said reinforcements. However, the flexibility of the base plate is sufficient enough to obtain an excellent adaption of the base plate to the surface of the heat sink. Additionally, due to the structural strength of said reinforcements, stable bows may be formed which maintain their structure even after spanning the base plate to the heat sink of the internal structure of the power module. The dimension thereby corresponds to the surface of all reinforcements with respect to the surface of the matrix, or the base plate as such, respectively.

According to another preferred embodiment of the present invention, the matrix is formed as a metal layer formed on and between the reinforcements. In this embodiment, the base plate according to the invention may be produced in an easy manner leading to cost savings as well as time savings during the formation.

In this regard, it is preferred that the reinforcements are fully covered by the metal layer. This enables the base plate according to the invention to have an enhanced structural stability. Furthermore, especially if a ductile metal is used for forming the matrix, the contact between the base plate and the cooling fin is further improved.

According to a further preferred embodiment of the present invention, the maxim value of the coefficient of thermal expansion (CTE) of the base plate lies in a range of 8ppm/k -12ppm/k, in particular at 10ppm/k. This enables the base plate to match the coefficient of thermal expansion of the internal components of the power module. Thermal stresses can thus be minimized which improves the durability of the power module.

### Brief description of drawings

Additional features, characteristics and advantages of the subject-matter of the invention are disclosed in the subclaims, the figures and the following description of the respective figures and examples, which - in an exemplary fashion - show one embodiment and example of a base plate according to the invention.

In the figures:
Figure 1 shows a sectional side view of an arrangement of a power module;
Figure 2 shows a top view and a side view of a base plate according to a first embodiment of the invention;
Figure 3 shows a top view and a side view of a base plate according to a further embodiment of the invention;
Figure 4 shows a top view and a side view of a base plate according to a further embodiment of the invention;
Figure 5 shows a top view and a side view of a base plate according to a further embodiment of the invention; and
Figures 6a and 6b show a comparison of a contact between a base plate and a heat sink according to the state of the art and according to the invention.

### Description of embodiments

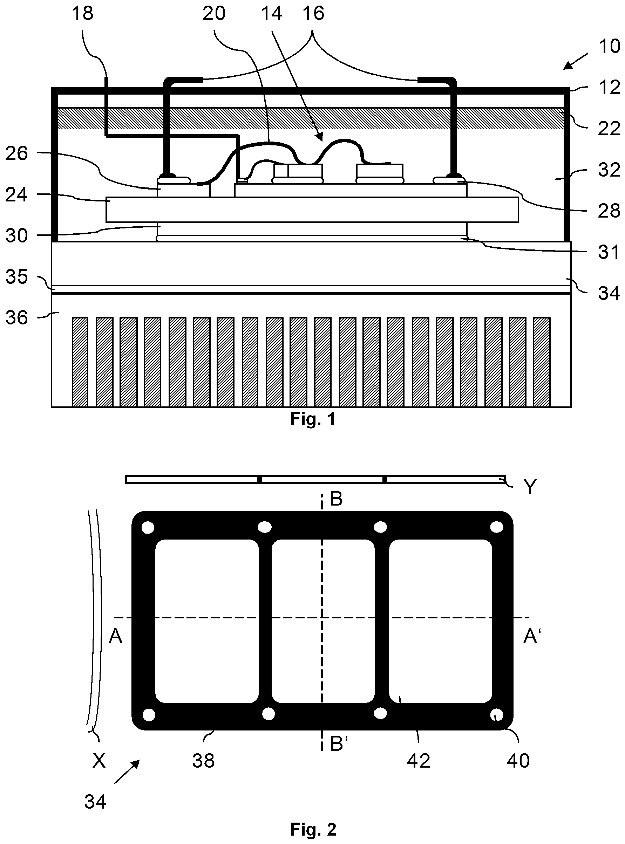

In figure 1, an arrangement of a power module 10 is schematically shown. In detail, the internal structure of said power module 10 is described. The power module 10 comprises a housing 12 in which at least one power semiconductor device 14 is arranged. The semiconductor device 14 may in an exemplary manner be an insulated gate bipolar transistor (IGBT), a diode, a metal oxide semiconductor field-effect transistor (MOSFET), or the like. According to figure 1, a diode and an IGBT are provided. The semiconductor device 14 or the plurality of semiconductor devices 14 are connectable via terminals 16 and preferably via an auxiliary terminal 18, wherein the semiconductor device 14 is preferably bonded by aluminium bond wires 20.

As an insulator, a layer of epoxy 22 may be arranged above the semiconductor device 14. The semiconductor device 14 may further be arranged on a substrate 24, which may be formed as an aluminium nitride ceramic insulator. The terminals 16 as well as the auxiliary terminal 18 are connected to the substrate 24 via a metallization 26, in particular a copper metallization, and a solder 28, or lot, respectively. However, comparable connections, such as ultrasonic welding, may be applied. Additionally, the substrate 24 is connected to a further metallization 30, in particular a copper metallization, at its bottom side. The remaining volume inside the housing 12 is filled e.g. with an insulating gel 32.

During operation, a power module 10 generates lots of thermal energy, or heat, respectively, due to the resistances in the electric conductors. Consequently, the generated heat has to be dissipated from the internal of the power module 10 to its outside. For this purpose, the power module 10 comprises a base plate 34. The base plate 34 is in thermal contact to the semiconductor device 14 on its upper side via the metallization 30 and a solder 31, and is furthermore thermally connected to a cooling fin, or heat sink 36, respectively. Between the base plate 34 and the heat sink 36, a heat conducting layer 35, such as a heat dissipation grease, gel, or mat, is provided.

Generally, the heat sink 36 is formed of a material with high thermal conductivity and allows dissipating the thermal energy, or the heat, respectively, from the inside of the power module 10 to the environment. Thus, the heat flows from the internal structure of the power module 10 through the base plate 34 and the heat sink 36 to the outside of the power module 10 in order to secure the power module 10 to work properly.

A base plate 34 according to the invention is schematically shown in figure 2. The base plate 34 comprises a matrix 38 which is formed of metal. Preferably, the matrix 38 is formed of aluminium. This metal is rather ductile and may be deformed to get a very close contact to the surface of the heat sink 36. However, the matrix 38 may be formed of any metal which is appropriate. In particular, next to aluminium as such, alloys are preferred which comprise aluminium as a component and especially as the main component thereof.

In order to further improve the contact between the base plate 34 and the heat sink 36, the surface roughness of the base plate 34 has to be as low as possible. Suitable values of the surface roughness lie in the range of < 3µm, in particular of < 2,3µm. This reduces the formation of cavities having a big volume and deteriorating the heat dissipation performance of the power module 10 between the base plate 34 and the heat sink 36.

In the matrix 38, through holes 40 are provided for securing the base plate 34 to the heat sink 36. The through holes 40 are formed in the matrix 38, or bulk material, respectively, since the reinforcements 42 are hard to machine. The securing of the base plate 34 to the heat sink 36 may be realized by screws which are screwed in said heat sink 36, or by another connection which securely fixes the base plate 34 to the heat sink 36.

In order to enable good heat dissipation, at least two reinforcements 42 are arranged in the matrix 38. The reinforcements 42 are separated from each other in that they are positioned next to each other but arranged spaced apart. In particular, the reinforcements 42 are typically made of a ceramic compound, especially of silicon carbide (SiC) and therefore offer an excellent thermal conductivity. Silicon carbide particularly allows the reinforcements 42 to have a good structural strength and furthermore to have good heat-dissipation properties.

It is preferred that a plurality of through holes 40 are provided in the matrix 38 along the length as well as along the width of the base plate 34, wherein no reinforcement 42 is provided between the through holes 40 along the width of the base plate 34.

The embodiment of figure 2 comprises in a non limiting way three reinforcements 42. They are embedded in the metal of the matrix 38 and preferably completely covered by said metal, or matrix 38, respectively. In a preferred example, the matrix 38 and thus the base plate 34 may have a dimension in the range of 120mm x 160mm to 170mm x 210mm. In an especially preferred example, the base plate 34 may be formed in a dimension of 137mm x 187mm. Each reinforcement may be formed at least at dimensions of 50mm x 100mm, in a preferred embodiment of 57mm x 104mm.

In the example according to figure 2, the reinforcements 42 are fully embedded in the ductile material of the matrix 38, or the aluminium material, respectively. Additionally, the cavities, or pores, of the ceramic material of the reinforcements 42 are completely filled with the material of the matrix 38, in particular aluminium, which thus preferably completely covers the reinforcements and all gaps there between.

The base plate 34 has to fulfil different functions/requirements. It has to conduct the heat from the inside of the power module 10 to the environment. The base plate 34 thus acts as a heat spreader to conduct the heat over its surface to the heat sink 36. Therefore the thermal conductivity must be as high as possible (> 180W/(mK) (20°C)). This is realized by forming the matrix 38 from aluminium and by using silicon carbide as material for the insert, or reinforcement 42, respectively.

In order to get an as close surface contact between the base plate 34 and the heat sink 36 as possible, the bottom side of the base plate 36 may be curved. This is apparent in the cross sectional view along the line B-B', which is defined by the reference sign X in figure 2. Due to the curved geometry of the base plate 34, or the formation of a bow, respectively, during the fixation to the heat sink 36 the base plate 34 is spanned to the heat sink 36 leading to an improved contact of the base plate 34 to the heat sink 36. However, according to the invention, it is sufficient that the base plate 34 is only partly formed as a bow. This means that the curvature may be limited to a bow being formed over the width of the base plate 34, like it can be seen from the cross sectional view X of figure 1. In contrast, a curvature over the length of the base plate 34 is not necessary, like this may be seen from the cross sectional view across the line A-A', which is defined by the reference sign Y in figure 1. However, it is of course possible to form the base plate 34 with a bow along the length of the base plate 34, for example along the full length, a half or along one third, according to the desired properties of the base plate 34. According to the invention, the width is the shorter side of the base plate with respect to its length.

Additionally, the maximum bow deflection height of the base plate 34 according to the invention may be 100µm ± 50µm.

A good flexural strength and fracture toughness are thus useful to prevent cracking. The flexural strength of the base plate 34 may lie in the range of between 300MPa and 500MPa, in particular at 400MPa, whereas the fracture toughness may lie in the range of 7MPa m^{1/2} to 9MPa m^{1/2}, in particular at 8.1MPa m^{1/2}.

The process of preparing a base plate 34 according to the invention may be as follows.

First, a ceramic preform, is produced. This may be realized, for example, by sintering e.g. a ceramic material, preferably silicium carbide, having open pores, in particular in the form of a foam. In a further step, the so prepared preform may be shaped, if necessary. As an example, the preform may be stamped or machined to get the desired shape, or geometry, respectively. The shape of the preform is preferably rectangular or square. However, depending on the geometry of the heat sink 36, the reinforcements 42 may have any shape which may be positioned on the heat sink 36 such, that the base plate 34 is in close contact to said heat sink 36. After shaping the preform in the desired manner, at least two of the preforms are placed in a form. Afterwards, liquid metal, preferably aluminium, is infiltrated in the form at a high temperature and at a high pressure, thereby filling the pores of the preform and the gaps between the composites. The content of silicium carbide with respect to the reinforcement 42 may be 62vol% - 28vol% for optimal mechanical bulk properties. Additionally, the preforms are preferably fully covered by the metal.

The described process enables the reinforcements 42 to be embedded in the metallic material enabling the latter to form a matrix 38 in which the reinforcements 42 are arranged. Consequently, the matrix 38 may be formed by covering the preform with a metallic material, preferably with aluminium.

With respect to the above, it is preferable to locate the reinforcements 42 such, that the reinforcements 42 are arranged with a distance in the range of 1mm to5mm, in particular of 3mm. Such a distance between the reinforcements 42 is essential to provide a sufficient flexibility of the base plate 34. If the reinforcements 42 are positioned too close to each other, such flexibility will be prevented because of the stiffness and structural strength of the reinforcements 42. However, in order to get sufficient heat dissipation, the distance of the reinforcements 42 should be limited.

Additionally, if the reinforcements 42 are located with a distance between each other going below a certain level, the risk of cracks to be formed in the matrix material may occur due to the fact that the plastic deformation may exceed the potential of the matrix material. Thus the stress at the contact zone between the matrix 38 and the reinforcements 42 may be too high.

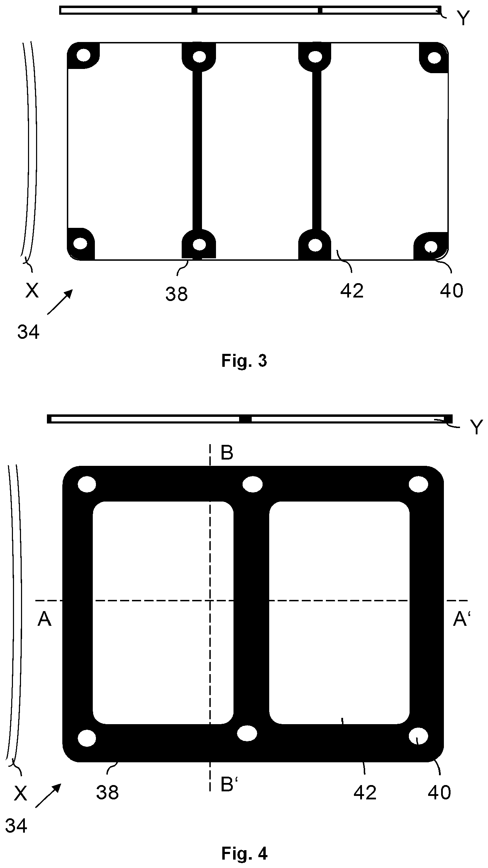

In figure 3, a further example of a base plate 34 according to the invention is shown. According to figure 3, again, the base plate 34 comprises three reinforcements 42. However, as may clearly be seen, the reinforcements 42 have a much bigger surface with respect to figure 2. According to figure 3, the matrix 38, or the metallic compound, respectively, is mainly formed of a layer, or a coating of the metal provided on the reinforcements 42, thereby filling the gaps between the respective reinforcements 42. In this case the heat dissipation capacity is greater with respect to figure 2.

A still further embodiment of a base plate 34 according to the invention is shown in figure 4. The embodiment according to figure 4 generally corresponds to the embodiment of figure 2. However, according to figure 4, only two instead of three reinforcements 42 are present. In this embodiment, the base plate 34 as such may be smaller leading to the advantage that it may be used in smaller power modules. By providing a continuous matrix 38 in which two separated reinforcements 42 are arranged, the base plate 34 is still flexible enough leading to an improved contact between the base plate 34 and the surface of the heat sink 36. In a preferred example of this embodiment, the matrix 38 and thus the base plate 34 may have a dimension in the range of 120mm x 100mm to 170mm x 150mm. In an especially preferred example, the base plate 34 may be formed in a dimension of 137mm x 127mm. Each reinforcement 42 may be formed at least at dimensions of 50mm x 100mm, in a preferred embodiment of 57mm x 104mm.

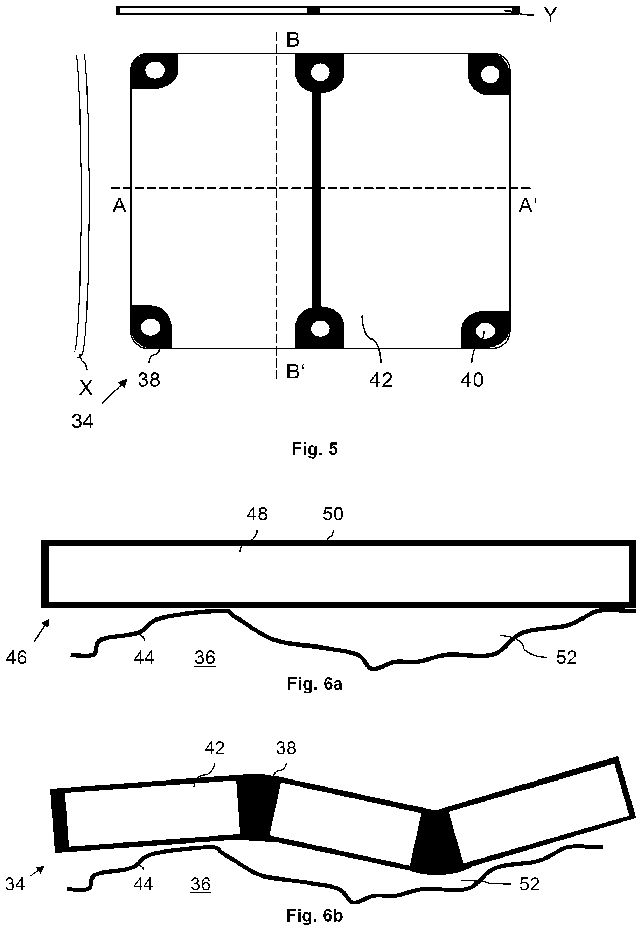

Shown in figure 5 is a further embodiment of the present invention relating to a base plate 34 still comprising two reinforcements 42. In this embodiment, the base plate 34 is comparable to that of figure 3 especially with respect to the size of the reinforcements 42.

In figures 6a and 6b, a comparison between the contact of a base plate 46 according to the state of the art with the surface 44 of a heat sink 36 with respect to a contact between a base plate 34 according to the invention with the surface 44 of a heat sink 36 is schematically shown.

According to figure 6a, a base plate 46 according to the state of the art is shown, which is in contact with the surface 44 of a heat sink 36. The base plate 46 comprises a reinforcement 48 which is covered by a metallic layer 50. The metallic layer 50 as well as the reinforcement 48 is formed in a continuous way. Due to the roughness of the surface 44, cavities 52 are formed between the base plate 46 and the surface 44 of the heat sink 36. These cavities 52 generally prevent a good heat flow between the base plate 46 and the heat sink 36 thereby deteriorating the heat dissipation properties.

According to figure 6b, a base plate 34 according to the invention is shown. The base plate 34 comprises a continuous matrix 38 in which at least two, according to figure 6b three separated and independent reinforcements 42 are arranged. Due to the flexibility of the matrix 38, especially in the region of the gaps between the reinforcements 42, the base plate 34 has the ability to deform, or to bend, respectively and thus to adapt to the topography of the surface 44 of the heat sink 36. This allows potentially present cavities 52 to be much smaller. Consequently, a much closer contact between the base plate 34 and the surface 50 is reached. The heat dissipation properties are thus improved.

Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope.

### Reference signs list

- 10: power module
- 12: housing
- 14: semiconductor device
- 16: terminal
- 18: auxiliary terminal
- 20: aluminium bond wires
- 22: epoxy
- 24: substrate
- 26: metallization
- 28: solder
- 30: metallization
- 31: solder
- 32: insulating gel
- 34: base plate
- 35: heat conducting layer
- 36: heat sink
- 38: matrix
- 40: through holes
- 42: reinforcement
- 44: surface
- 46: base plate
- 48: reinforcement
- 50: metallic layer
- 52: cavity

## Claims

1. Base plate, in particular for a power module (10), comprising a matrix (38) formed of metal, in particular of aluminium, wherein at least two reinforcements (42) are provided in said matrix (38) next to each other, and wherein the reinforcements (42) are spaced apart from each other and are plate-shaped, **characterized in that** a plurality of through holes (40) for securing the base plate (34) to a heat sink (36) are provided in the matrix (38) along the length as well as along the width of the base plate (34), wherein no reinforcement (42) is provided between the through holes (40) along the width of the base plate (34).

2. The base plate according to claim 1, wherein the at least two reinforcements (42) are formed from silicium carbide.

3. The base plate according to one of the preceding claims, wherein the reinforcements (42) are arranged with a distance from each other in the range of 1mm to 5mm, in particular of 3mm.

4. The base plate according to one of the preceding claims, wherein the base plate (34) is at least partly formed as a bow.

5. The base plate according to claim 4, wherein the maximum bow deflection height is 100µm ± 50µm.

6. The base plate according to one of claims 4 or 5, wherein a bow is formed only over the width of the base plate (34).

7. The base plate according to one of the preceding claims, wherein all reinforcements (42) together have dimensions of at least 70% with respect to the dimension of the base plate (34), in particular of at least 85% with respect to the dimension of the base plate (34).

8. The base plate according to one of the preceding claims, wherein the matrix (38) is formed as a metal layer formed on and between the reinforcements (42).

9. The base plate according to one of the preceding claims, wherein the maximum value of the coefficient of thermal expansion of the base plate (34) lies in a range of 8-12ppm/k, in particular at 10ppm/k.

## Patentansprüche

1. Grundplatte, insbesondere für ein Leistungsmodul (10), umfassend eine aus Metall, insbesondere aus Aluminium, gebildete Matrix (38), wobei mindestens zwei Verstärkungen (42) in der Matrix (38) nebeneinander vorgesehen sind und wobei die Verstärkungen (42) voneinander beabstandet und plattenförmig sind, **dadurch gekennzeichnet, dass** eine Vielzahl von Durchgangslöchern (40) zum Befestigen der Grundplatte (34) an einer Wärmesenke (36) in der Matrix (38) sowohl entlang der Länge als auch entlang der Breite der Grundplatte (34) vorgesehen sind, wobei zwischen den Durchgangslöchern (40) entlang der Breite der Grundplatte (34) keine Verstärkung (42) vorgesehen ist.

2. Grundplatte nach Anspruch 1, wobei die mindestens zwei Verstärkungen (42) aus Siliciumcarbid ausgebildet sind.

3. Grundplatte nach einem der vorhergehenden Ansprüche, wobei die Verstärkungen (42) in einem Abstand im Bereich von 1 mm bis 5 mm, insbesondere von 3 mm, angeordnet sind.

4. Grundplatte nach einem der vorhergehenden Ansprüche, wobei die Grundplatte (34) mindestens teilweise als ein Bogen ausgebildet ist.

5. Grundplatte nach Anspruch 4, wobei die maximale Bogenauslenkungshöhe 100 µm ±50 µm beträgt.

6. Grundplatte nach einem der Ansprüche 4 oder 5, wobei ein Bogen nur über die Breite der Grundplatte (34) ausgebildet ist.

7. Grundplatte nach einem der vorhergehenden Ansprüche, wobei alle Verstärkungen (42) zusammen Abmessungen von mindestens 70% bezüglich der Abmessung der Grundplatte (34), insbesondere von mindestens 85% bezüglich der Abmessung der Grundplatte (34), haben.

8. Grundplatte nach einem der vorhergehenden Ansprüche, wobei die Matrix (38) als eine auf und zwischen den Verstärkungen (42) ausgebildete Metallschicht ausgebildet ist.

9. Grundplatte nach einem der vorhergehenden Ansprüche, wobei der maximale Wert des Wärmeausdehnungskoeffizienten der Grundplatte (34) in einem Bereich von 8 - 12 ppm/k, insbesondere bei 10 ppm/k, liegt.

## Revendications

1. Plaque de base en particulier pour un module de puissance (10), comprenant une matrice (38) formée de métal, en particulier d'aluminium, au moins deux renforcements (42) étant prévus dans ladite matrice (38) l'un à côté de l'autre et les renforcements (42) étant espacés les uns des autres et étant en forme de plaque,
**caractérisée en ce qu'**une pluralité de trous traversants (40) pour fixer la plaque de base (34) à un puits thermique (36) sont prévus dans la matrice (38) le long de la longueur ainsi que le long de la largeur de la plaque de base (34), aucun renforcement (42) n'étant prévu entre les trous traversants (40) le long de la largeur de la plaque de base (34).

2. Plaque de base selon la revendication 1, dans laquelle les au moins deux renforcements (42) sont formés de carbure de silicium.

3. Plaque de base selon l'une des revendications précédentes, dans laquelle les renforcements (42) sont agencés à une distance les uns des autres dans une plage de 1 mm à 5 mm, en particulier de 3 mm.

4. Plaque de base selon l'une des revendications précédentes, dans laquelle la plaque de base (34) est au moins en partie formée sous forme d'arc.

5. Plaque de base selon la revendication 4, dans laquelle la hauteur de déflection maximale de l'arc est de 100 µm +- 50 µm.

6. Plaque de base selon l'une des revendications 4 et 5, dans laquelle un arc est formé seulement sur la largeur de la plaque de base (34).

7. Plaque de base selon l'une des revendications précédentes, dans laquelle tous les renforcements (42) présentent ensemble des dimensions d'au moins 70 % par rapport à la dimension de la plaque de base (34), en particulier d'au moins 85 % par rapport à la dimension de la plaque de base (34).

8. Plaque de base selon l'une des revendications précédentes, dans laquelle la matrice (38) est formée en tant que couche de métal formée sur et entre les renforcements (42).

9. Plaque de base selon l'une des revendications précédentes, dans laquelle la valeur maximale du coefficient de dilatation thermique de la plaque de base (34) est compris dans une plage de 8-12 ppm/k, en particulier vaut 10 ppm/k.
